Europäisches Patentamt

(19) European Patent Office

Office européen des brevets

(11) EP 0 836 768 B1

(12) # EUROPEAN PATENT SPECIFICATION

(45) Date of publication and mention
of the grant of the patent:
**19.03.2003 Bulletin 2003/12**

(21) Application number: **96916667.7**

(22) Date of filing: **24.05.1996**

(51) Int Cl.[7]: **H03M 1/56**, H03K 23/00

(86) International application number:
**PCT/US96/07769**

(87) International publication number:
**WO 96/037962 (28.11.1996 Gazette 1996/52)**

(54) **MONOLITHIC ANALOG-TO-DIGITAL CONVERTER**

MONOLITISCHER ANALOG-DIGITAL-WANDLER

CONVERTISSEUR ANALOGIQUE/NUMERIQUE MONOLITHIQUE

(84) Designated Contracting States:
**DE FR GB**

(30) Priority: **25.05.1995 US 450339**

(43) Date of publication of application:
**22.04.1998 Bulletin 1998/17**

(73) Proprietor: **Lockheed-Martin IR Imaging Systems
Lexington, MA 02173 (US)**

(72) Inventor: **BUTLER, Neal, R.
Acton, MA 01720 (US)**

(74) Representative: **de Beaumont, Michel et al
1, rue Champollion
38000 Grenoble (FR)**

(56) References cited:
**US-A- 3 393 298**

- **1992 IEEE NUCLEAR SCIENCE SYMPOSIUM AND MEDICAL IMAGING CONFERENCE (NSS/MIC'92), ORLANDO, FL, USA, 25-31 OCT. 1992, vol. 40, no. 4, pt.1, ISSN 0018-9499, IEEE TRANSACTIONS ON NUCLEAR SCIENCE, AUG. 1993, USA, pages 721-723, XP002013683 MILGROME O B ET AL: "A monolithic CMOS 16 channel, 12 bit, 10 microsecond analog to digital converter integrated circuit"**
- **EUROMICRO 85. SHORT NOTES, BRUSSELS, BELGIUM, 3-6 SEPT. 1985, vol. 16, no. 2-3, ISSN 0165-6074, MICROPROCESSING & MICROPROGRAMMING, SEPT.-OCT. 1985, NETHERLANDS, pages 95-99, XP002013684 VRANES P A: "An implementation of a high speed Gray to binary code converter"**
- **IEEE TRANSACTIONS ON NUCLEAR SCIENCE, vol. 36, no. 1, 1 February 1989, pages 646-649, XP000112430 COUSINS R D ET AL: "32-CHANNEL DIGITAL 6-BIT TDC WITH 2.5 NS LEAST COUNT"**

## Description

### 1. Field of the Invention

The present invention relates generally to analog-to-digital converters and more particularly to multiple analog-to-digital converters integrated on a monolithic integrated circuit.

### 2. Discussion of the Related Art

In conventional single slope methods of analog-to-digital conversion, a clocked comparator is employed to compare a sampled and held signal with an analog ramp. The clocked comparator in turn generates a signal that is used to clock a latch circuit that stores the state of a digital counter when the sampled and held signal is equal to the analog ramp. The stored counter value is a digital representation of the magnitude of the analog signal. Integrated circuit applications of this type of circuit provide an array of such circuits.

Conventional single slope analog-to-digital converters encounter resolution and speed limitations due to limitations on maximum clock rate. One limit to the maximum clock rate with the convention single slope converter is due to metastability. Metastability is defined as the instability of a flip-flop when the clock and data inputs change simultaneously. Although the output of a flip-flop cannot, in principle, be guaranteed to have settled to a valid logic state after any given period of time, the probability that the output has not settled decreases exponentially with time. After about 69 time constants, for example, the probability of the output not settling is less than $10^{-30}$, which is acceptable for most applications.

Due to this problem, the clock rate must be reduced substantially to allow the flip-flop, which synchronizes the comparator output to the system clock time, to recover from metastability. Conventional devices require the metastability resolution to be done at a frequency determined by the time resolution of the conversion. As a result, conventional devices are limited to clock rates much less than their circuits are capable of.

The invention improves on conventional devices by removing the requirement to synchronize individual converters to the master clock and by generating a higher resolution digital code. It is therefore one object of the invention to provide an analog-to-digital converter that realizes a significant improvement in resolution and speed compared to conventional converters.

IEEE Trans. on Nuclear Science, Aug. 1993, pages 721-723, Milgrome et al., discloses an analog-to-digital converter as defined in the preamble of claim 1.

### Summary Of The Invention

The invention provides an analog to digital converter as defined in claim 1, with a corresponding method as defined in claim 19.

### Brief Description Of The Drawings

In the drawings, which are incorporated herein by reference and in which like elements have been given like reference characters,

FIG. 1 is a schematic block diagram of an analog-to-digital converter according to the invention;
FIG. 2 is a schematic block diagram of the metastability resolving circuit illustrated in FIG. 1;
FIG. 2A is a schematic block diagram of the analog waveform generator illustrated in FIG. 1;
FIG. 3 is a schematic block diagram of an array of analog-to-digital converters according to the invention;
FIG. 4 is a schematic block diagram of the clock multiplying phase locked loop illustrated in FIG. 3;
FIG. 5 is a schematic block diagram of the 90° phase shifter illustrated in FIG. 3;
FIG. 6 is a schematic block diagram of an alternate embodiment of the circuit illustrated in FIG. 3;
FIG. 7 is a schematic block diagram of a two phase voltage controlled oscillator and squaring circuit used in the circuit of FIG. 6;
FIG. 8 is a detailed schematic circuit diagram of the voltage controlled oscillator illustrated in FIG. 7;
FIG. 9 is a detailed schematic circuit diagram of the squaring circuit illustrated in FIG. 7; and
FIG. 10 is a timing diagram illustrating the temporal relationship among the least significant bits of the Gray code signal.

### Detailed Description

For purposes of illustration only, and not to limit generality, the present invention will now be explained with reference to particular embodiments and operational parameters. One skilled in the art will appreciate, however, that the present invention is not limited to the particular operational parameters described.

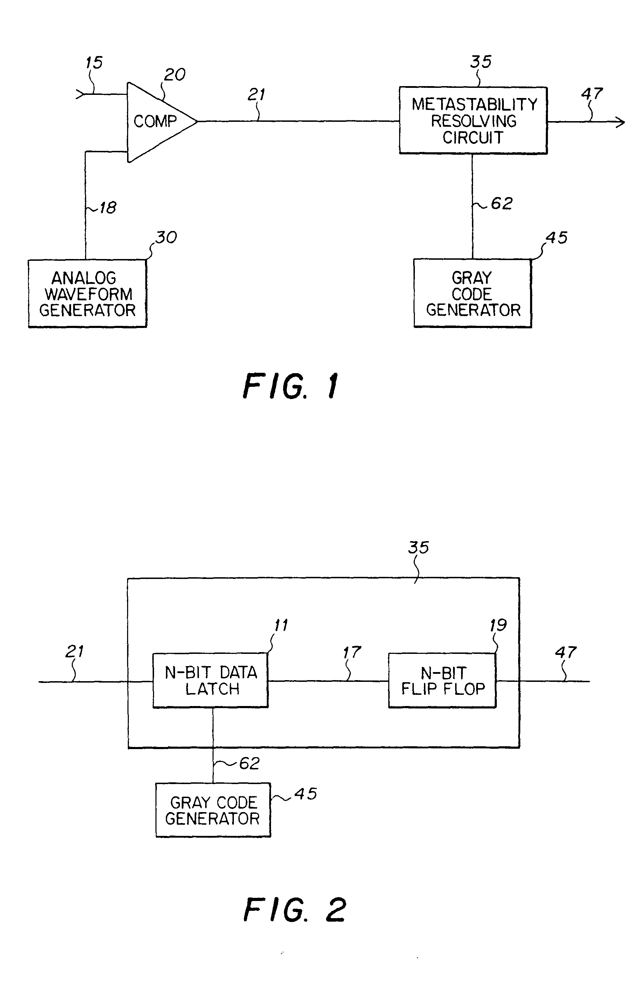

Reference is now made to FIG. 1, which is an overall schematic block diagram of the analog-to-digital converter of the invention. Analog input signal 15, the analog signal to be converted, is connected to one input of an unclocked analog comparator 20. The other input of the comparator 20 is connected to an analog ramp signal 18. Analog waveform generator 30 generates the analog ramp signal 18. When the analog ramp signal 18 substantially equals the analog input signal 15, the comparator generates output signal 21. The comparator output signal 21 is connected to a control input of a metastability resolving circuit 35. Synchronized with the analog waveform generator 30 is a Gray code generator 45 that generates a digital Gray code on a digital Gray code bus 62. The digital Gray code bus 62 is connected to a data input of the metastability resolving circuit 35. The metastability resolving circuit 35 stores the states of the digital Gray code on bus 62 in response to an active state of the comparator output signal 21. As a result, the digital output signal 47 of the metastability resolving circuit 35 is a digital representation of the magnitude of the analog input signal 15 when the magnitude of the analog ramp signal 18 equals the magnitude of the analog input signal 15.

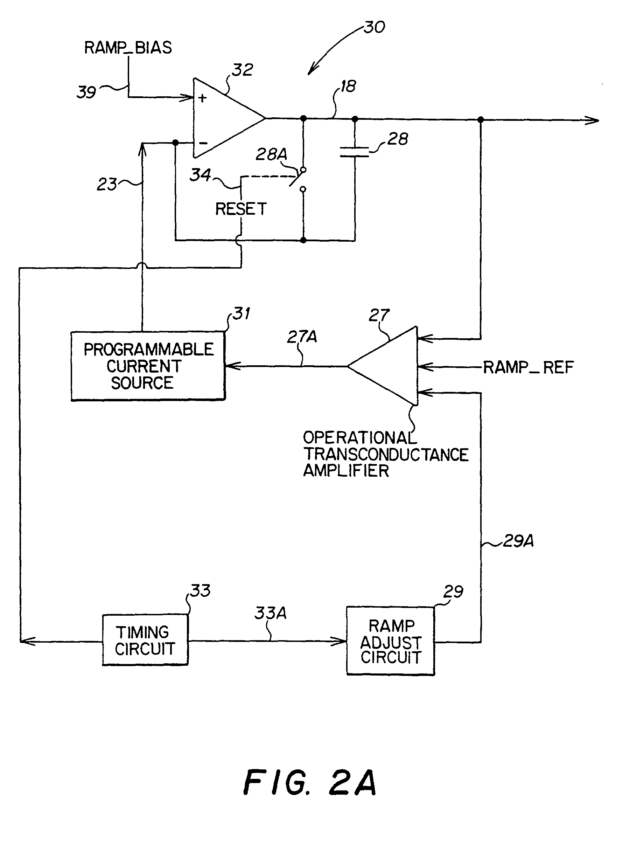

Reference is now made to FIG. 2, which illustrates the metastability resolving circuit 35 in more detail. Comparator output signal 21 is connected to the control input of an N-Bit data latch 11. N is the number of bits of resolution that the analog signal 15 is digitized (converted) into by the analog-to-digital converter. N can be any number and is typically between eight and sixteen for most applications. The N-bit data latch 11 data input is connected to the digital Gray code bus 62 from the Gray code generator 45. The data latched by the N-bit data latch 11 (which is a code generated by Gray code generator 45) is provided on line 17 to N-bit flip-flop 19. N-bit flip-flop 19 resolves the metastability of the system by storing the data on line 17 a predetermined time period after the N-bit data latch 11 has stored the state of the Gray code generator 45. The digital output 47 is provided as described above.

Reference is now made to FIG. 2A, which illustrates a schematic block diagram of analog waveform generator 30 illustrated in FIG. 1. Operational amplifier 32 provides the analog ramp signal 18 by providing an output signal to integration capacitor 28. RESET signal 34 is generated by timing circuit 33 and activates switch 28A to discharge capacitor 28 when a new conversion is to be initiated. One input 39 of operational amplifier 32 in connected to a RAMP_BIAS signal and a second input 23 is connected to the output of a programmable current source 31. Programmable current source 31 is controlled by operational transconductance amplifier 27. Amplifier 27 has a first input connected to the analog ramp signal 18. A second input of amplifier 27 is connected to a ramp reference voltage RAMP_REF. A third input of amplifier 27 is connected to the output of ramp adjust circuit 29. The starting voltage of the analog ramp is adjustable by changing the RAMP_BIAS voltage. The slope of the analog ramp signal 18 is controlled by amplifier 27. By changing the output of programmable current source 31 in response to a current signal 27A from transconductance amplifier 27, the slope of the analog ramp signal 18 can be changed. In response to control signal 33A from timing circuit 33, issued just before ramp signal 18 is to terminate, ramp adjust circuit 29, via control signal 29A, turns amplifier 27 on to sample the difference between the RAMP_REF voltage and the voltage of analog ramp signal 18. Transconductance amplifier 27 converts this voltage difference to a current 27A that is used to control programmable current source 31. After programmable current source 31 has been adjusted, timing circuit 33, via control signal 33A, turns amplifier 27 off to open the feedback loop, issues RESET signal 34 to discharge capacitor 28 using switch 28A, and then opens switch 28A to begin another integration cycle.

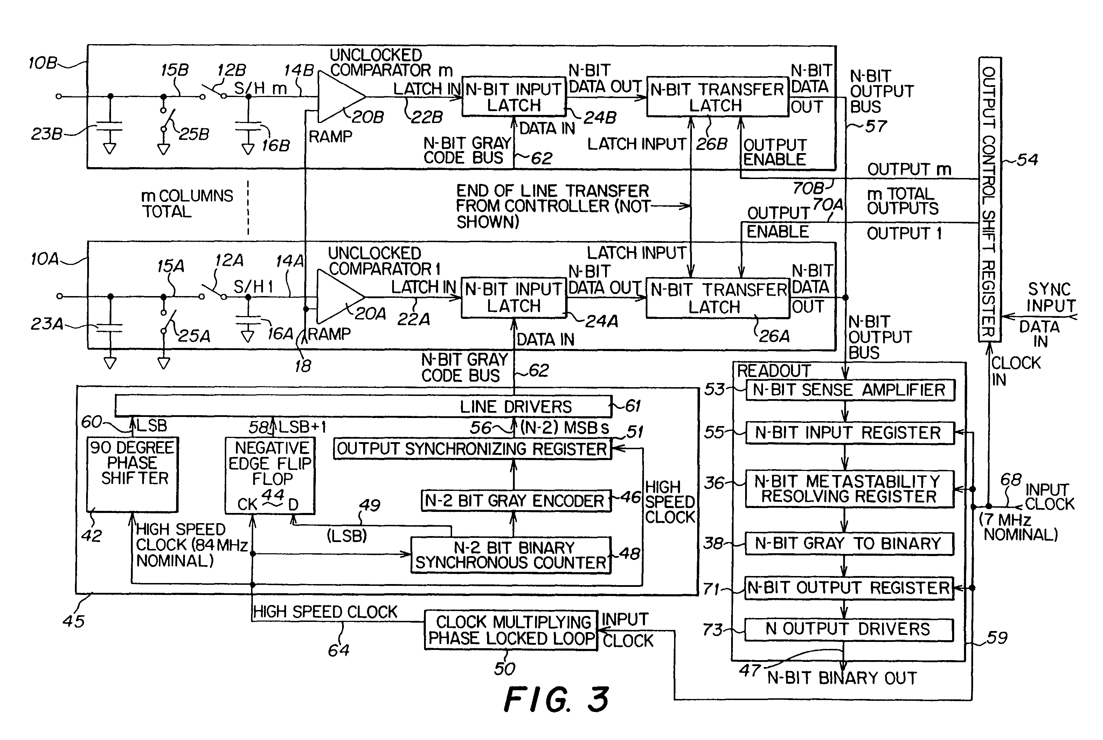

Reference is now made to FIG. 3, which is a schematic block diagram of parallel analog-to-digital converters 10A and 10B. Only two converters are shown for clarity; there could be m number of converters in an array. In one preferred embodiment there are 328 converters in an array. Each analog-to-digital converter is connected to the digital Gray code bus 62 and an output bus 57. The digital Gray code bus 62 is connected to each data input of the m data latches. For clarity, only the connections to data latches 24A and 24B are shown. The data input of each data latch is driven by the gray code generator 45. The N-bit output bus 57 is connected to the data output of each transfer latch (latches 26A and 26B being illustrated) and is read by multiplexer readout circuit 59.

The analog signal on line 15A, the signal to be converted, is stored by capacitor 23A until sampling switch 12A is closed, thereby transferring the charge to capacitor 16A. Capacitor 16A integrates the analog signal 15A until switch 12A is opened. After a predetermined time interval has passed, switch 12A is opened and switch 25A is closed, thus resetting capacitor 23A at the start of each conversion period. Those skilled in the art will recognize that any charge transfer device or circuit may be used to transfer the signal to be compared. During the read out phase the sampled signal 14A is compared to an analog ramp signal 18 by comparator 20A. When the sampled signal 14A is equal to or at some predetermined potential with respect to the analog ramp signal 18, the output 22A of the comparator 20A activates latch 24A. The output of the comparator 20A is connected to the enable input of latch 24A. The latch 24A, connected to digital Gray code bus 62, stores the state of the gray code count at the time the analog ramp signal 18 equals the sampled signal 14A in response to comparator output signal 22A. The output of latch 24A is provided to a transfer latch 26A. Output control shift register 54, connected to transfer latches 26A and 26B via outputs 70A and 70B, selects the output of a particular analog-to-digital converter from the array of converters. The output of each transfer latch is connected to sense amplifier 53 via N-bit output bus 57, part of multiplexer readout circuit 59. Only one transfer latch is active and supplying an output to bus 57 at any one time. The output control register 54 is synchronized with input clock 68.

Multiplexer readout circuit 59 will now be described. One skilled in the art will appreciate that each of the circuit blocks in multiplexer readout circuit 59 is N-bits wide to accomodate the number of bits from each transfer latch. The output of sense amplifier 53 is connected to the input of input register 55 which is clocked by input clock 68. Input register 55 latches the data on N-bit output bus 57 from whichever N-bit transfer latch has been enabled by output control shift register 54. The output of register 55 is connected to the input of a metastability resolving register 36 that is also clocked by input clock 68. Metastability resolving register 36 is clocked so that one full clock cycle after the state of N-bit output bus 57 has been latched into input register 55, the data from input register 55 is provided to the input of metastability resolving register 36. Register 36 resolves the metastability of the conversion that may have arisen when the digital signal on bus 62 was latched by output signal 22A from analog comparator 20A. Circuit analysis of this latch train arrangement has indicated that the metastability of the system is improved by a factor of at least $2^{30}$ by the addition of metastability resolving register 36. The output of the metastability resolving register 36 is connected to a Gray code decoder 38 that converts the Gray code signal to a standard binary signal. The Gray code decoder 38 may use an exclusive-ORing (XORing) process in which the output of each latch in the metastability resolving register 36 is exclusive-ORed (XORed) with an adjacent bit that has in turn been exclusive-ORed with another bit, and so on. The standard binary N-bit code output by Gray code decoder 38 is provided to the data input of N-bit output register 71, which latches the output value in response to input clock 68. The output of output register 71 is provided to N output drivers 73 that provide the N-bit converted binary output signal 47.

Input clock 68 is also provided to a clock multiplying phase locked loop circuit 50 that generates a high speed clock 64. In one embodiment of the invention, the clock multiplier is a 12x clock multiplier. In one embodiment of the invention, for example, input clock 68 is a 7 MHz nominal clock and clock multiplier 50 increases this by a factor of 12 to 84 MHz.

Gray code generator 45 will now be described. The digital Gray code on bus 62, which in one embodiment of the invention is an N-bit binary gray code, is generated by concatenation of three bit streams: a least significant bit 60, a next-to-least significant bit 58 and a N-2 bit gray code word 56. The high speed clock 64 clocks an N-2 bit synchronous binary counter 48. The N-2 bit synchronous counter 48 provides an output signal to an N-2 bit Gray code encoder 46. The Gray code encoder provides the N-2 most significant bits 56 of the digital Gray code on bus 62 via output synchronizing register 51 and line drivers 61. Gray code encoder 46 provides a Gray code by XORing each bit output by counter 48 with an adjacent output bit.

The high speed clock 64 and the N-2 bit synchronous counter's least significant bit 49 is connected to a negative edge triggered flip-flop 44. The negative edge triggered flip-flop 44 provides the next to least significant bit signal, LSB+1 58, as part of the digital Gray code on bus 62.

The high speed clock 64 is also connected to a 90° analog phase shifter 42. The 90° phase shifter 42 generates the least significant bit signal, LSB 60, as part of the digital Gray code on bus 62 by shifting the high speed clock 64 by 90°.

In one example embodiment, N is equal to 13 bits, synchronous counter 48 and Gray code encoder 46 provide the 11 most significant bits on Gray code bus 62. A 12th bit (LSB+1) is supplied by dividing a 75 (approximately) MHz clock by two and then latching it with the falling edge of the 75 MHz clock in flip-flop 44. The 13th bit (LSB) is generated by delaying the 75 MHz clock by precisely 90°, ¼ of a complete clock cycle, in closed loop phase shifter 42. This type of phase shifter is sometimes referred to as a delay locked loop.

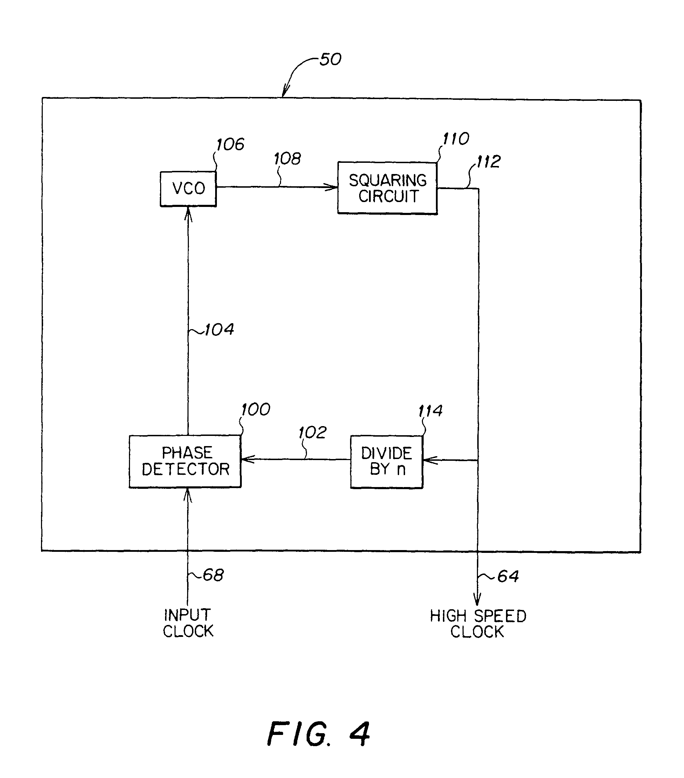

Reference is now made to FIG. 4, which illustrates in more detail, the clock multiplying phase locked loop 50 of FIG. 3. Clock multiplier 50 includes a phase detector 100 that detects a difference in phase between input clock 68 and a frequency divided version of high speed clock 64 on line 102. The output 104 of phase detector 100 is used to control a frequency multiplying voltage controlled oscillator (VCO) 106. VCO 106 increases the frequency of input clock 68 by a predetermined factor. In one example, VCO 106 increases the frequency of input clock 68 by a factor of 12 to produce high speed clock 64. The output 108 of VCO 106 is provided to a "squaring" circuit 110. The function of squaring circuit 110 is to shape the output signal 112 so that high speed clock 64 has a fifty percent duty cycle, i.e., a "square" output. High speed clock 64 is also provided to a divide by n circuit 114 that divides the frequency by a factor n so that the frequency of the clock signal delivered on line 102 is equal to the frequency of input clock 68. As discussed before, in one embodiment, if VCO 106 increases the clock frequency by a factor of 12, then n would be 12 so that divide by n circuit 114 reduces the frequency of high speed clock 64 by a factor of 12 before providing that signal to phase detector 100. In one embodiment, VCO 106 may include a ring oscillator.

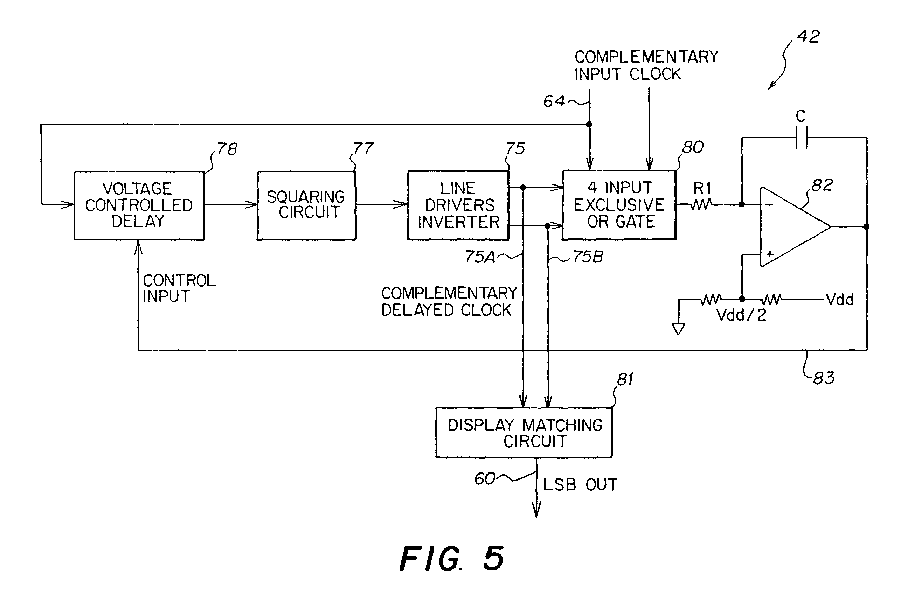

Reference is now made to FIG. 5, which FIG. is a schematic block diagram of the 90° analog phase shifter 42 illustrated in FIG. 3. High speed clock 64 and its complement from clock multiplier 50 are connected to the first and second clocking inputs of a four input exclusive or (XOR) gate 80. XOR gate 80 includes an output coupled to the inverting input of a high gain integrating amplifier 82. Amplifier 82 outputs a control signal 83 which is coupled to a control input of a voltage controlled delay circuit 78. The voltage controlled delay circuit 78 also receives a clocking signal from the high speed clock 64. The high gain of amplifier 82 ensures that the delay is always 90° even in the presence of variations in component values and clock frequency. The voltage controlled delay circuit 78 outputs a delayed signal in response to the control signal 83 and clock 64 to a "squaring" circuit 77. Squaring circuit 77 shapes the delayed signal so that it is symmetrical and has a fifty percent duty cycle (i.e., a "square" output) and outputs a signal to the input of line driver inverter 75. Squaring circuit 77 is similar to squaring circuit 110, previously described. Line driver inverter 75 outputs a first line driver inverter signal 75A and a second line driver inverter signal 75B to third and fourth inputs of the four input exclusive OR gate 80. The first and second line driver inverter signals are also coupled to first and second inputs of a delay matching circuit 81. Signals 75A and 75B comprise a complementary delayed clock. Delay matching circuit 81 ensures that the delay experienced by each signal 75A and 75B is the same, so that the signals remain in the proper phase relationship with each other. The delay matching circuit 81 outputs LSB 60.

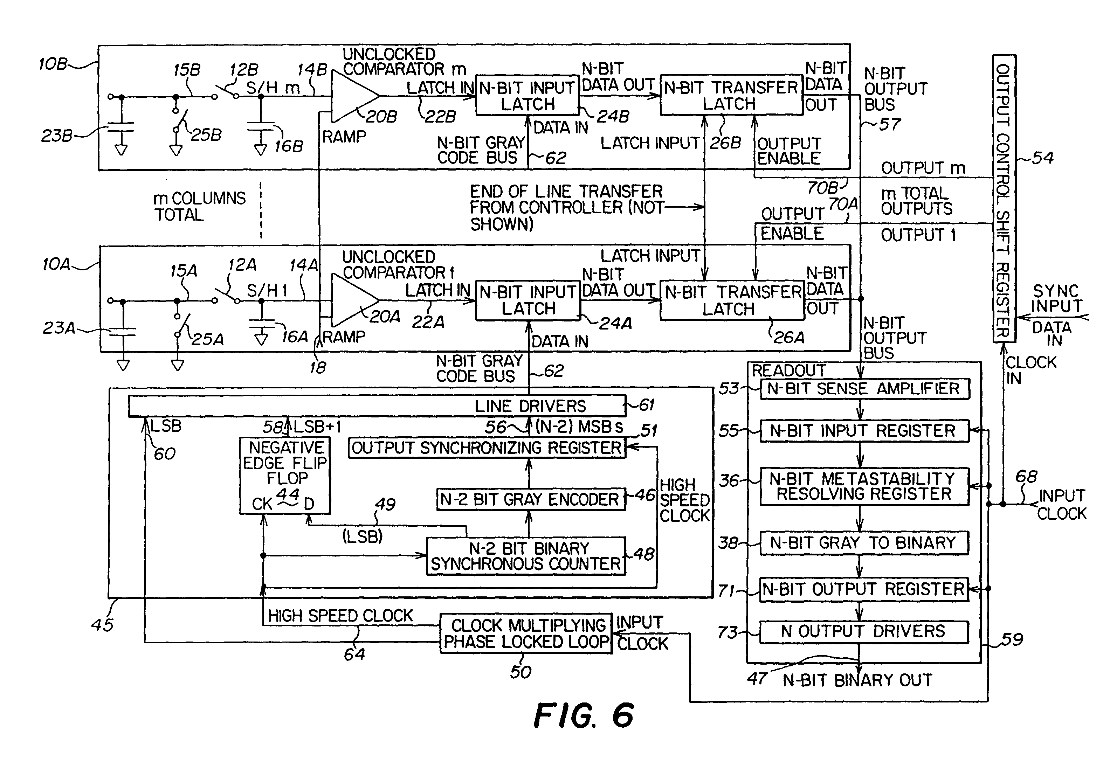

Reference is now made to FIG. 6, which is a schematic block diagram of an alternate embodiment of the circuit of FIG. 3. In the circuit of FIG. 6, the 90° phase shifter 42 of FIG. 3 has been eliminated. In addition, clock multiplier 50 has been modified so as to provide LSB 60 directly. In all other respects, the operation of FIG. 6 is the same as already described in connection with FIG. 3.

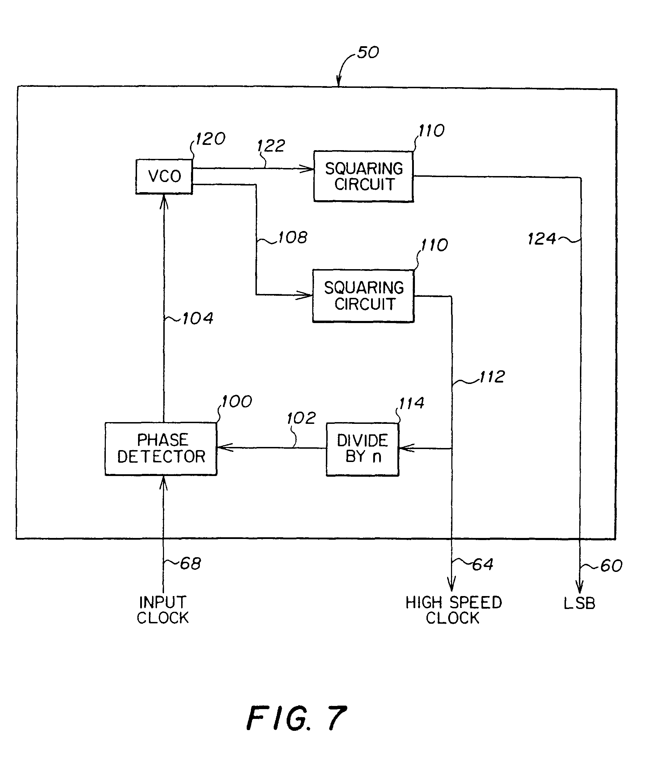

Reference is now made to FIG. 7, which FIG. is a schematic block diagram of the clock multiplier 50 of FIG. 6. In FIG. 7, as in FIG. 4, input clock 68 is provided to a phase detector 100 that provides a control signal 104, in response to input clock 68 and signal 102, to a voltage controlled oscillator 120. VCO 120 also multiplies the output frequency provided on line 108 to squaring circuit 110 in order to generate high speed clock 64 on line 112. The output of squaring circuit 110 on line 112 is additionally provided to divide by n circuit 114 that delivers control signal 102 in the same manner as described in connection with FIG. 4.

VCO 120 also provides a second output 122 that is phase shifted 90° with respect to output 108 and then provided to another squaring circuit 110. Squaring circuit 110 operates in the manner described in connection with FIG. 4 to provide a "square" output for the LSB 60 on line 124.

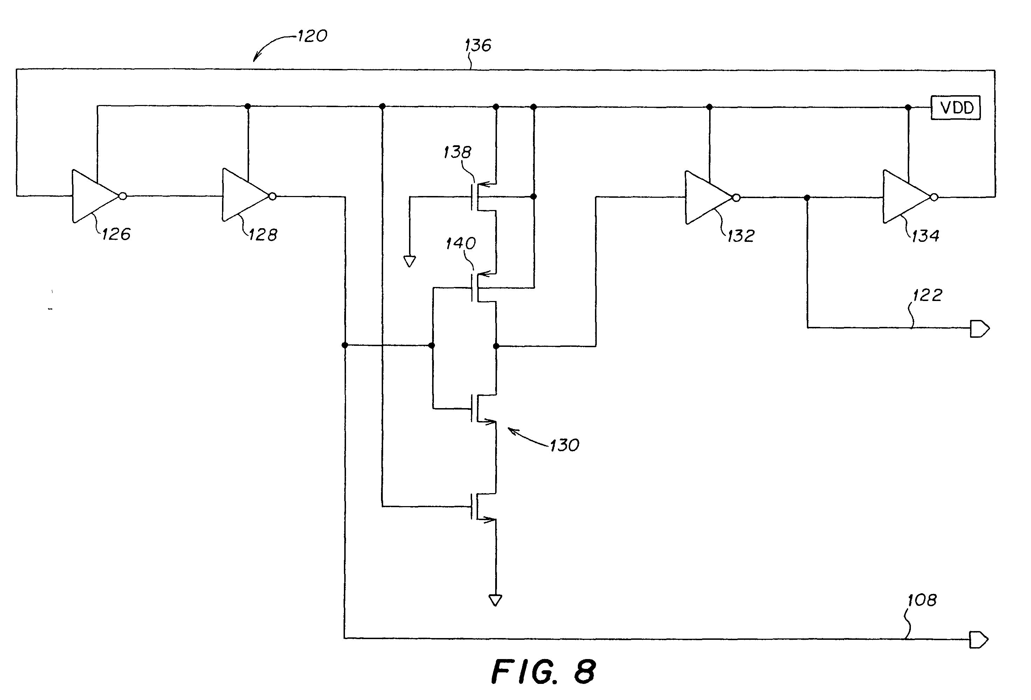

Reference is now made to FIG. 8, which FIG. is a schematic diagram of VCO 120. VCO 120 provides two outputs 108, 122 that are 90° out of phase from each other. VCO 120 is a ring oscillator formed from an odd number of invertor stages connected in a loop. In particular, VCO 120 includes inverters 126, 128, 130, 132, and 134. The output of inverter 134 is connected via line 136 to the input of inverter 126 in order to form the ring. If t is the time delay of one of the inverters and p is the number of stages in the oscillator, then the oscillation frequency f is:

$$(1) \qquad f = 1/(2pt)$$

Changing the frequency is accomplished by changing the power supply voltage of the invertor chain, thus changing time t. In the case of the CMOS invertor, the propagation delay increases as the supply voltage is decreased.

The phase shift per stage in the ring oscillator is:

$$(2) \qquad \text{Phase/stage} = 180/p$$

For example, in the five stage oscillator illustrated in FIG. 8, the phase shift per stage is 36°. Thus, a tap two stages away from the main output will have a 72° phase shift, while a tap three stages away from the main output will have a 108° phase shift. If all of the inverters are identical, then a 90° phase shift is not possible.

However, if the different invertors in the ring oscillator are not identically constructed, then a 90° phase shift between invertors in the ring oscillator can be obtained. In a CMOS inverter, the delay through the inverter depends upon a number of factors, including the size and shape of the component transistors and the amount of capacitive loading on its output. Adjusting any of these factors to increase the propagation delay of one of the inverters with respect to the remaining inverters in the ring can be used to provide the required 90° phase shift.

In VCO 120 illustrated in FIG. 8. the propagation delay of inverter 130 is adjusted by adding two transistors 138 and 140 that are biased so as to always be in the on state. This increases the propagation delay through inverter 130 so that the total delay through inverters 134, 126, and 128 is about the same as the delay through modified inverter 130 and inverter 132. If the delay through inverters 134, 126, and 128 is the same as the delay through modified inverter 130 and inverter 132, then there is exactly a 90° phase shift between outputs 108 and 122.

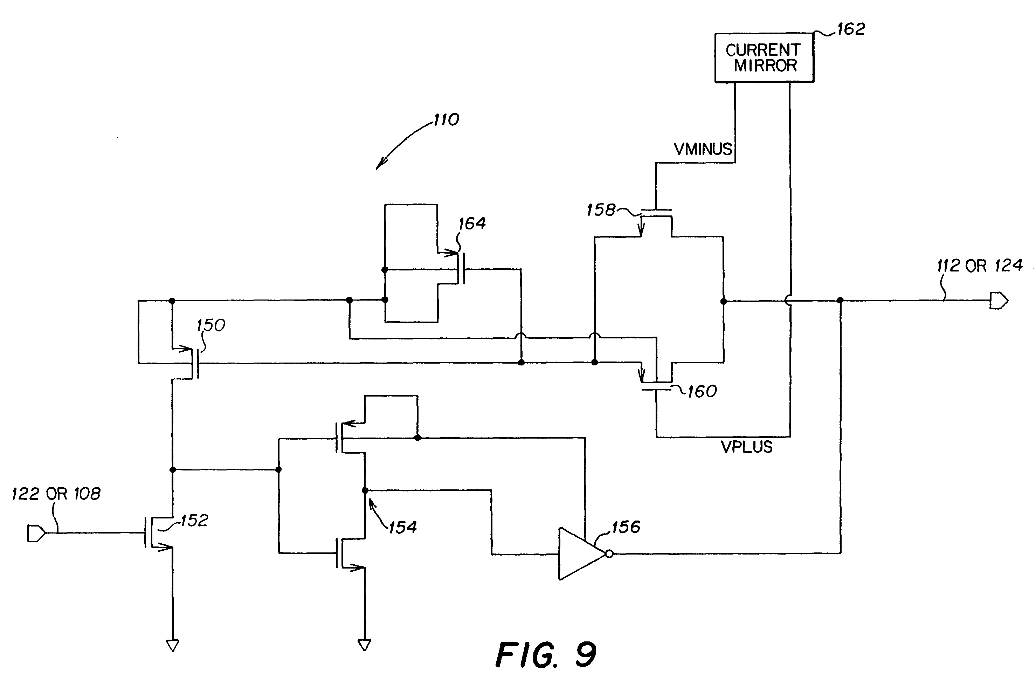

Reference is now made to FIG. 9, which FIG. is a schematic circuit diagram of squaring circuit 110 illustrated in FIG.s 4 and 7. Squaring circuit 77 is FIG. 5 also operates in the same manner as squaring circuit 110.

As illustrated in FIG. 9, the output of VCO 120 is provided to squaring circuit 110. Obviously, in the case of the circuit illustrated in FIG. 7. two squaring circuits are provided, one for each output of VCO 120.

Typically, VCO 120 operates at a reduced voltage compared to the rest of the circuitry and therefore outputs 108 and 122 need to be translated to the higher voltage level of the rest of the circuits. In addition, the propagation delay generally will not be the same for the rising and falling edges of the output signal and therefore the output of the level translator circuit will not be symmetrical, i.e., have a "square" output or fifty percent duty cycle, even though the signals internal to the ring oscillator are symmetric. Circuit 110 thus incorporates the level translator into a closed loop feedback circuit that adjusts the input threshold as needed to maintain the symmetry of the output signal.

The level shifter includes transistors 150 and 152, and inverters 154 and 156. Two current source transistors 158 and 160 are controlled by voltages VMINUS and VPLUS. The voltages VMINUS and VPLUS are supplied by current mirror 162 and control the amount of current delivered by the transistors 158 and 160. A feedback loop of signal 112 or 124 is provided through transistors 158, 160, transistor 164, to level shifting transistors 150 and 152. If the waveform of output signal 112 or 124 becomes asymmetrical, i.e., not "square", transistors 158, 160 respond by changing the gate voltage on the input stage current source transistor 150 in a direction that reestablishes symmetry of the output. Additionally, transistor 164, used as a capacitor, filters out any ripple voltage and sets the response time of the feedback loop.

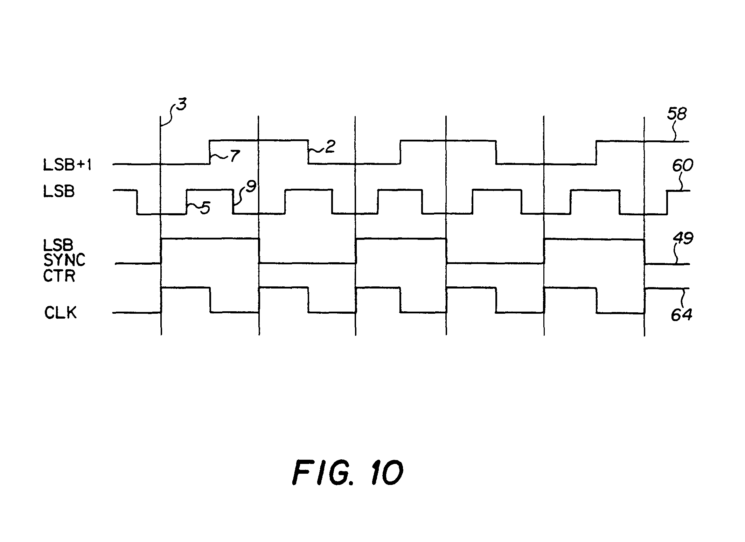

Reference is now made to FIG. 10, which is a timing diagram of the LSB 60 and LSB+1 58. The timing diagram of FIG. 10 illustrates the operation of either the circuit of FIG. 3 or the circuit of FIG. 6. The high speed clock 64 transitions from low to high at time 3. The least significant bit 49 of the N-2 bit binary counter 48 transitions on the low to high transition of the high speed clock 64. The LSB 60, derived from the high speed clock 64, transitions high at time 5 and low at time 9. The LSB+1 58, derived from the counter least significant bit 49, transitions high at time 7 and low at time 2. The N-2 most significant bits 56 of the Gray encoded signal transition only at time 3 while the LSB 60 and LSB+1 58 signals do not change at time 3. At times 2, 5, 7, and 9 only one of these signals changes at a time, thus meeting the Gray code requirement of having only a single bit change when there is a change in the count.

One skilled in the art will appreciate that rather than using an input clock having a frequency that is multiplied in order to provide a high speed clock, an external high speed clock could be used to control counter 48, flip-flop 44, and 90° phase shifter 42.

One advantage of the present invention is that the Gray code least significant bit frequency may be equal to the frequency of the clock that is used to control the circuit. This means that the least significant bit frequency may be equal to the maximum toggle frequency for the flip-flop. Conventionally, for a typical Gray code, the master clock frequency is four times the frequency of the least significant bit of the Gray code. In the present invention, by contrast, the frequency of the least significant bit of the Gray code can be equal to the clock frequency. Therefore, the clock frequency is only limited by the inherent frequency limitations of the clock counter circuitry itself. This allows for higher conversion rates then conventionally achievable.

For a typical 2 micron CMOS process at room temperature, this frequency limit is about 150 MHz, and about 500 MHz at 80°K. For a typical 1 micron CMOS process, this frequency limit is about 500 MHz at room temperature, and may be more than 1 Ghz at 80°K. In one embodiment of the invention, a 72 MHz master clock generates a Gray code with 3.5 ns resolution which allows a 13 bit conversion in 30 µs. A 500 MHz master clock generates a Gray code with 500 ps resolution, allowing a 16 bit conversion in 33 µs or 12 bits in 2 µs. With several hundred of these converters on one chip, the total conversion rate may be on the order of 100 MHz. The estimated power is less than 50 µw per channel. As a result, the present invention allows the relatively slow single slope method of analog-to-digital conversion, when a array of such converters are used on a single chip, to provide relatively high conversion rates, while consuming low amounts of power. Furthermore, the simple design of single slope analog-to-digital converters saves power and allows integration of a large number of these converters on a single integrated circuit, particularly when using CMOS technology.

A Gray code count is used as the digital signal to be stored when the comparator is activated because, by definition, only one bit changes for each increment of the code. Since only one of the Gray coded bits can be in the process of changing when the latch is enabled, only one of the sampled bits can exhibit metastability, and the resultant code will be uncertain by only one least significant bit. This is in contrast to the case when a standard binary code is used as the digital signal to be stored. Since more than one bit may be changing for each increment of the code, a number of the sampled bits can exhibit metastability.

The use of a Gray code count also advantageously allows the metastability resolution to be determined at a point in the circuit where there is more time to complete it, thus reducing the power and speed requirements of the circuitry. As a result, in the present invention, the metastability resolution can be postponed until after the multiplexing of the data when the data rate is considerably lower than the rate at which the data is provided by each analog-to-digital converter. In particular, in conventional circuits, the metastability resolution might typically be provided when the binary code from a counter is clocked into the N-bit data latches. This might require the metastability resolution to be performed in a very short time interval at a relatively high clock rate. As noted, by contrast, the present invention can accomplish this function using a significantly lower clock rate, which reduces the power and speed requirements of the circuitry.

For example, a 75 MHz (approximately) clock may be used to generate the Gray code. This 75 MHz clock is generated from a 6 MHz (approximately) input clock. The 75 MHz clock is used only for the analog-to-digital conversion; the 6 MHz clock is used for all other functions of the integrated circuit.

By using an array of 328 converters, a conversion is completed in approximately 30 microseconds with a resolution of 13 bits. A conventional approach requires a master clock frequency of approximately 300 MHz, which is higher than the capability of, for example, a conventional 2 micron CMOS process. The use of a gray code allows the metastability resolution to be performed at a rate of 6 MHz on 13 bits rather than 300 MHz on 328 comparators.

The invention also provides a method of converting the analog signals from an array of analog-to-digital converters with a high effective clock rate, and increased resolution. A multitude of input signals, one for each converter, are sampled and held. Signals are formed by integrated the current from an analog source. This signal is held constant on a capacitor for the duration of the conversion process. Next, an analog ramp and a digital counter are simultaneously started. A comparator circuit compares the voltage of the ramp with the sampled and held voltage. When the two are equal, the output of the comparator changes state and causes the value of the digital counter to be stored in an N bit latch. The values stored in the array of latches, which are a digital representation of the various input voltages, are transferred in parallel to another array of latches. Then a new set of conversions can be performed while the results of the previous conversions are multiplexed to form a digital output signal.

For an array of converters, the digital counter and ramp generator are common to all converters. Each converter itself needs only a sample and hold, a comparator, and an array of digital latches.

The circuits of the present invention may be monolithically integrated in semiconductor form using convention CMOS technology.

Having thus described at least one illustrative embodiment of the invention, various alterations, modifications, and improvements will readily occur to those skilled in the art. Such alterations, modifications, and improvements are intended to be within the scope of the invention, which is defined in the following claims.

## Claims

1. Apparatus comprising:

   an analog ramp generator (30) to output an analog ramp signal (18);
   a Gray code generator (45) to output a sequence of digital counts;
   a plurality of converter circuits (10A, 10B) to convert analog signals to digital signals, each converter circuit coupled to the analog ramp generator and the Gray code generator so as to receive the analog ramp signal (18) and the sequence of digital counts, each of the plurality of converter circuits including:

   a comparator (20) to compare an analog signal to the analog ramp signal and to output a comparator output signal; and
   a first register (24) to store a digital signal during a conversion period as one digital count of the sequence of digital counts, in response to the comparator output signal;
   a multiplexer (26, 54), coupled to the first register (24A, 24B) of each converter circuit (10A, 10B) of the plurality of converter circuits, to select one digital signal from one of the plurality of converter circuits and output the selected digital signal (57);
   a Gray-to-binary converter (38) coupled to convert the selected digital signal to binary;
   the apparatus **characterized in that** it further comprises:

   a metastability resolving register (36) coupled to the multiplexer that stores the selected digital signal at a predetermined time after the conversion period and outputs a metastability resolved digital signal based on the selected digital signal, which metastability resolved signal is converted by the Gray-to-binary converter.

2. The apparatus of claim 1, wherein:

   each of the plurality of converter circuits converts a sequence of analog signals to a corresponding sequence of digital signals during a sequence of conversion periods;
   the metastability resolving register (36) includes an input clock (68) to store the sequence of digital signals at a first data rate; and
   the Gray code generator (45) outputs the sequence of digital counts at a second data rate, the second data rate being higher than the first data rate, each digital signal of the sequence of digital signals being stored in the first register (24) as one digital count of the sequence of digital counts.

3. The apparatus of claim 2, wherein the metastability resolving circuit (59) stores each digital signal of the sequence of digital signals at the predetermined time after each conversion period of the sequence of conversion periods.

4. The apparatus of claim 1, further including an input clock (68) having a first frequency, the multiplexer (26, 54) being coupled to the input clock so as to select a sequence of digital signals from the plurality of converter circuits (10A, 10B) and output the sequence of selected digital signals at a first data rate based on the first frequency of the input clock.

5. The apparatus of claim 4, wherein the multiplexer (26, 54) outputs each selected digital signal during a respective first cycle of the input clock (68).

6. The apparatus of claim 5, further comprising a metastability resolving circuit (59) including an input register (55), coupled to the input clock (68) and the multiplexer (26, 54), to receive the sequence of selected digital signals at the first data rate and store each selected digital signal during the respective first cycle of the input clock (68).

7. The apparatus of claim 6, wherein the metastability resolving circuit (59) further includes the metastability resolving register (36), coupled to the input clock (68) and the input register (55), to receive the sequence of selected digital signals at the first data rate and store each selected digital signal during a respective second cycle of the input clock after the respective first cycle, the metastability resolving register (36) outputting the metastability resolved digital signal for each selected digital signal.

8. The apparatus of claim 7, wherein:

the Gray code generator (45) outputs the sequence of digital counts at a second data rate, the second data rate being higher than the first data rate, and
for each converter (10A, 10B), the digital signal is stored in the first register (24A, 24B) as one digital count of the sequence of digital counts.

9. The apparatus of claim 8, wherein the Gray code-to-binary converter (38), is coupled to the metastability resolving register (36) so as to receive the metastability resolved digital signal, to output a metastability resolved standard binary digital signal based on the metastability resolved digital signal.

10. The apparatus of claim 9 further including a high speed clock having a second frequency higher than the first frequency of the input clock, wherein:

the digital signal includes N bits;
each digital count of the sequence of digital counts includes a least significant bit, a next-to-least significant bit, and (N-2) most significant bits;
the Gray code generator (45) is coupled to the high speed clock and constructed and arranged to toggle the least significant bit at the second frequency of the high speed clock, such that the Gray code generator generates the sequence of digital counts at the second data rate.

11. The apparatus of claim 10, wherein the second frequency of the high speed clock is at least 12 times higher than the first frequency of the input clock.

12. The apparatus of claim 10, wherein the Gray code generator (45) includes:

a synchronous counter (48), coupled to the high speed clock (64), having a synchronous counter output including a counter least significant bit;
an XOR Gray encoder (46), coupled to the synchronous counter output, to output the (N-2) most significant bits; and
a first phase shifter (44), coupled to the high speed clock and the synchronous counter so as to receive the counter least significant bit, to output the next-to-least significant bit.

13. The apparatus of claim 12, wherein the Gray code generator (45) further includes a second phase shifter (42), coupled to the high speed clock, to output the least significant bit as a phase shifted version of the high speed clock.

14. The apparatus of claim 13, wherein the second phase shifter (42) outputs the least significant bit as a 90° phase shifted version of the high speed clock, the second phase shifter including:

a voltage controlled delay (78), having a control input and coupled to the high speed clock, to output a delayed clock signal based on both of the high speed clock and a control signal received at the control input;
a squaring circuit (77), coupled to the voltage controlled delay so as to receive the delayed clock signal, to output a 50% duty cycle delayed clock signal;
a phase detector circuit (75, 80), coupled to the high speed clock and the squaring circuit so as to receive the 50% duty cycle delayed clock signal, to output the least significant bit and a phase signal based on a difference between the high speed clock and the 50% duty cycle delayed clock signal; and
an amplifier (82), coupled to the phase detector circuit so as to receive the phase signal, to output the control signal to the voltage controlled delay.

15. The apparatus of claim 12, further comprising a high speed clock generator (50) to receive the input clock (68) and multiply the first frequency of the input clock to output the high speed clock.

16. The apparatus of claim 15, wherein:

the high speed clock generator (50) includes a divider (114) to output the high speed clock (60) and a modified high speed clock (64) having a third frequency less than the second frequency of the high speed clock;
the high speed clock provides the least significant bit; and
the modified high speed clock, instead of the high speed clock, is coupled to the synchronous counter (48) and the first phase shifter (44).

17. The apparatus of claim 15, wherein the apparatus is a monolithic device integrated on a semiconductor chip.

18. The apparatus of claim 17, wherein the monolithic device is a CMOS device.

19. An analog-to-digital signal conversion method, comprising steps of:

generating an analog ramp signal (18);
generating a sequence of Gray code digital counts;
comparing a plurality of analog signals to the analog ramp signal to generate a corresponding plurality of comparison signals;
respectively storing a plurality of digital signals in a plurality of first registers (24A, 24B) during a conversion period, each digital signal of the plurality of digital signals based on a corresponding analog signal of the plurality of analog signals, each digital signal being stored in a corresponding first register based on one comparison signal of the plurality of comparison signals;
sequentially selecting digital signals from the plurality of first registers;
converting the selected digital signals to corresponding binary signals;
the method **characterized in that** it further comprises a step of:

transferring the sequentially selected digital signals to a metastability resolving register (36) at a predetermined time after the conversion period to resolve a metastability of the sequentially selected digital signals, before they are converted to said corresponding digital signals.

20. The method of claim 19, wherein:

the step of respectively storing the plurality of digital signals includes a step of storing a sequence of digital signals during a sequence of conversion periods based on a corresponding sequence of analog signals; and
the step of transferring includes a step of transferring the sequence of digital signals to the metastability resolving register (36) at a first data rate.

21. The method of claim 20, wherein:

the step of storing a sequence of digital signals includes a step of storing each digital signal of the sequence of digital signals in the at least one corresponding first register (24) during each conversion period of the sequence of conversion periods; and
the step of transferring the sequence of digital signals includes a step of transferring each digital signal of the sequence of digital signals to the metastability resolving register (36) at the predetermined time after each conversion period.

22. The method of claim 20, wherein the step of storing a sequence of digital signals includes steps of:

generating the sequence of digital counts at a second data rate, the second data rate being higher than the first data rate; and
storing each digital signal of the sequence of digital signals in the first register (24) as one digital count of the sequence of digital counts.

23. The method of claim 19, wherein:

the step of sequentially selecting digital signals includes a step of selecting a sequence of digital signals from the plurality of first registers at a first data rate; and
the step of transferring the sequentially selected digital signal includes a step of transferring the sequence of selected digital signals to the second register at the first data rate.

24. The method of claim 23, wherein the step of respectively storing a plurality of digital signals includes steps of:

generating the sequence of digital counts at a second data rate, the second data rate being higher than the first data rate; and
storing each digital signal in the respective first register as one of the sequence of digital counts.

25. The method of claim 24, wherein the step of converting the sequentially selected digital signal further comprises converting the sequentially selected digital signal transferred to the second register from a Gray coded digital signal to a metastability resolved standard binary digital signal.

26. The method of claim 24, wherein the step of selecting a sequence of digital signals includes a step of selecting a sequence of digital signals based on an input clock having a first frequency such that the sequence of digital signals is selected at the first data rate.

27. The method of claim 26, wherein the step of generating the sequence of Gray code digital counts includes a step of generating the sequence of Gray code digital counts based on a high speed clock having a second frequency higher than the first frequency of the input clock, such that the sequence of digital counts is generated at the second data rate.

28. The method of claim 27, wherein:

each digital signal of the plurality of digital signals includes N bits;

each Gray code digital counts of the sequence of Gray code digital counts includes a least significant bit; and

the step of generating the sequence of Gray code digital counts based an the high speed clock includes a step of toggling the least significant bit at the second frequency of the high speed clock.

29. The method of claim 28, wherein the step of generating the sequence of Gray code digital counts based on the high speed clock includes a step of generating at least one of the N bits of the Gray code digital counts based on phase shifting of the high speed clock.

30. The method of claim 29, wherein the step of generating at least one of the N bits of the Gray code digital counts based on phase shifting of the high speed clock includes a step of generating the least significant bit as a 90° phase shift version of the high speed clock.

**Patentansprüche**

1. Eine Vorrichtung die folgendes aufweist:

einen Analogrampengenerator (30) zur Ausgabe eines analogen Rampensignals (18);

einen Gray-Code-Generator (45) zur Ausgabe einer Sequenz von digitalen Zählungen oder Zählerständen;

eine Vielzahl von Wandlerschaltungen (10A, 10B) zur Umwandlung von Analogsignalen in Digitalsignale, wobei jede Wandlerschaltung mit dem Analogrampengenerator und dem Gray-Code-Generator gekoppelt ist, um das analoge Rampensignal (18) und die Sequenz von Digitalzählungen zu empfangen, wobei jede der Vielzahl von Wandlerschaltungen folgendes aufweist:

einen Komparator (20) zum Vergleichen eines Analogsignals mit dem Analogrampensignal und zur Ausgabe eines Komparatorausgangssignals; und

ein erstes Register (24) zur Speicherung eines Digitalsignals während einer Umwandlungsperiode als eine Digitalzählung der Sequenz von Digitalzählungen, und zwar ansprechend auf das Komparatorausgangssignal;

einen Multiplexer (26, 54), gekoppelt mit dem ersten Register (24A, 24B), jeder Wandlerschaltung (10A, 10B) der Vielzahl von Wandlerschaltungen, um ein Digitalsignal aus einer der Vielzahl von Wandlerschaltungen auszuwählen und das ausgewählte Digitalsignal (57) abzugeben;

einen Gray-zu-binär-Wandler (38) angekoppelt zur Umwandlung des ausgewählten Digitalsignals in ein Binärsignal;

wobei die Vorrichtung **dadurch gekennzeichnet ist, dass** sie ferner folgendes aufweist:

ein Metastabilitätsauflösungs- oder Resolverregister (36) gekoppelt mit dem Multiplexer zum Speichern des ausgewählten Digitalsignals zu einer vorbestimmten Zeit nach der Umwandlungs- oder Wandlungsperiode und zur Ausgabe eines metastabilitätsaufgelösten Digitalsignals basierend auf dem ausgewählten Digitalsignal, wobei das metastabilitätsaufgelöste Signal umgewandelt wird durch den Gray-zu-binär-Wandler.

2. Vorrichtung nach Anspruch 1, wobei:

jede der Vielzahl von Wandlerschaltungen eine Sequenz von Analogsignalen in eine entsprechende Sequenz von Digitalsignalen während einer Sequenz von Wandlungs- bzw. Umwandlungsperioden wandelt bzw. umwandelt;

das Metastabilitätsauflösungsregister (36) einen Eingangstakt (68) aufweist zur Speicherung der Sequenz von Digitalsignalen mit einer ersten Datenrate; und

der Gray-Code-Generator (45) die Sequenz von digitalen Zählungen mit einer zweiten Datenrate abgibt, die höher ist als die erste Datenrate und wobei jedes Digitalsignal der Sequenz von Digitalsignalen in dem ersten Register (24) gespeichert wird, und zwar als eine digitale Zählung oder ein digitaler Zählerstand der Sequenz von digitalen Zählungen oder Zählerständen.

3. Vorrichtung nach Anspruch 2, wobei die Metastabilitätsauflösungsschaltung (59) jedes Digitalsignal der Srequenz von Digitalsignalen zu einer vorbestimmten Zeit nach jeder Wandlungsperiode der Sequenz von Wandlungsperioden speichert

4. Vorrichtung nach Anspruch 1, wobei ferner ein Eingangstakt oder Clock (68) mit einer ersten Frequenz vorgesehen ist, und der Multiplexer (26, 54) mit dem Eingangstakt derart gekoppelt ist, um so eine Sequenz von Digitalsignalen aus der Vielzahl von Wandlerschaltungen (10A, 10B) auszuwählen und die Sequenz der ausgewählten Digitalsignale mit einer ersten Datenrate basierend auf der ersten Frequenz des Eingangstakts auszugeben.

5. Vorrichtung nach Anspruch 4, wobei der Multiplexer (26, 54) jedes ausgewählte Digitalsignal während eines entsprechenden ersten Zyklus des Eingangstakts (68) abgibt.

6. Vorrichtung nach Anspruch 5 mit einer Metastabilitätsauflösungsschaltung (59) einschließlich einem Eingangsregister (55) gekoppelt mit dem Eingangstakt (68) und dem Mulitplexer (26, 54) zum Empfang der Sequenz ausgewählter Digitalsignale mit der ersten Datenrate und zur Speicherung jedes ausgewählten Digitalsignals während dem entsprechenden ersten Zyklus des Eingangstakts (68).

7. Vorrichtung nach Anspruch 6, wobei ferner die Metastabilitätsauflösungsschaltung (59) ferner das Metastabilitätsauflösungsregister (36) aufweist, und zwar gekoppelt mit dem Eingangstakt (68) und dem Eingangsregister (55) zum Empfang der Sequenz von ausgewählten Digitalsignalen mit der ersten Datenrate und zur Speicherung jedes ausgewählten Digitalsignals während eines entsprechenden zweiten Zyklus des Eingangstakts nach dem entsprechenden ersten Zyklus, wobei das Metastabilitätsauflösungsregister (36) das metastabilitätsaufgelöste Digitalsignal für jedes ausgewählte Digitalsignal abgibt.

8. Vorrichtung nach Anspruch 7, wobei der Gray-Code-Generator (45) die Sequenz von digitalen Zählungen mit einer zweiten Datenrate abgibt, die höher ist als die erste Datenrate, und wobei für jeden Wandler (10A, 10B) das Digitalsignal in dem ersten Register (24A, 24B) als eine digitale Zählung der Sequenz von Digitalzählungen gespeichert wird.

9. Vorrichtung nach Anspruch 8, wobei der Gray-Code-zu-binär-Wandler (38) mit dem Metastabilitätsauflösungsregister (36) gekoppelt ist, um so das metastabilitätsaufgelöste Digitalsignal zu empfangen und ein metastabilitätsaufgelöstes Standard-Binär-Digitalsignal abzugeben, und zwar basierend auf dem metastabiltitätsaufgelösten Digitalsignal.

10. Vorrichtung nach Anspruch 9, wobei ferner ein Hochgeschwindigkeitstakt oder -Clock mit einer zweiten Frequenz höher als der ersten Frequenz des Eingangstakts oder -Clocks vorgesehen ist, und wobei ferner folgendes vorgesehen ist:

das Digitalsignal weist N-Bits auf;
jede Digitalzählung der Sequenz von Digitalzählungen weist ein am wenigsten signifikantes Bit, ein Bit am nächsten zum wenigsten signifikanten Bit gelegenes Bit und (N-2) am meisten signifikante Bits auf;
der Gray-Code-Generator (45) ist mit dem Hochgeschwindigkeitstakt gekoppelt und derart ausgebildet und angeordnet, um das am wenigsten signifikante Bit mit der zweiten Frequenz des Hochgeschwindgkeitstakts zu kippen oder zu schalten, derart, dass der Gray-Code-Generator die Sequenz von digitalen Zählungen mit der zweiten Datenrate erzeugt.

11. Vorrichtung nach Anspruch 10, wobei die zweite Frequenz des Hochgeschwindigkeitstakts mindestens zwölfmal höher liegt als die erste Frequenz des Eingangstaktes.

12. Vorrichtung nach Anspruch 10, wobei der Gray-Code-Generator (45) folgendes aufweist:

einen Synchronzähler (48) gekoppelt mit dem Hochgeschwindigkeitstakt (64) mit einer synchronen Zählerausgangsgröße einschließlich eines am wenigsten signifikanten Zähler-Bits;
einen XOR-Gray-Codierer (46) gekoppelt mit dem Synchronzählerausgang, um die (N-2) am meisten signifikanten Bits abzugeben; und
einen erster Phasenschieber (44) gekoppelt mit dem Hochgeschwindigkeitstakt und dem Synchronzähler, um so das am wenigsten signifikante Zählerbit zu empfangen und das Bit am nächsten zum am wenigsten signifikanten gelegene Bit auszugeben.

13. Vorrichtung nach Anspruch 12, wobei der Gray-Code-Generator (45) einen zweiten Phasenschieber (42) aufweist, und zwar gekoppelt mit dem Hochgeschwindigkeitstakt um das am wenigsten signifikante Bit als eine phasenverschobene Version des Hochgeschwindigkeitstakts auszugeben oder abzugeben.

14. Vorrichtung nach Anspruch 13, wobei der zweite Phasenschieber 42 das am wenigsten signifikante Bit als eine 90° phasenverschobene Version des Hochgeschwindigkeitstakts abgibt, und wobei der zweite Phasenschieber folgendes aufweist:

eine spannungsgesteuerte Verzögerung (78) mit einem Steuereingang und gekoppelt mit dem Hochgeschwindigkeitstakt, um ein verzögertes Taktsignal auszugeben, und zwar basierend auf sowohl dem Hochgeschwindigkeitstakt als auch dem Steuersignal empfangen an dem Steuereingang;

eine Quadrierschaltung (77) gekoppelt mit der spannungsgesteuerten Verzögerung, um so das verzögerte Taktsignal zu empfangen, um ein 50% arbeitszyklus- bzw. tastverhältnis-verzögertes Taktsignal abzugeben;

eine Phasendetektorschaltung (75, 80) gekoppelt mit dem Hochgeschwindigkeitstakt und der Quadrierschaltung um so das 50% arbeitszyklusbzw, tastverhältnis-verzögerte Taktsignal zu empfangen und um das am wenigsten signifikante Bit und ein Phasensignal abzugeben, welch letzteres auf einer Differenz zwischen dem Hochgeschwindigkeitstakt und dem 50% arbeitszyklus- bzw. tastverhältnis-verzögerten Taktsignals basiert; und

ein Verstärker (82) gekoppelt mit der Phasendetektorschaltung, um so das Phasensignal zu empfangen und das Steuersignal an die spannungsgesteuerte Verzögerung abzugeben.

15. Vorrichtung nach Anspruch 12, wobei ferner ein Hochgeschwindigkeitstaktgenerator (50) vorgesehen ist, um für den Eingangstakt (68) zu empfangen und die erste Frequenz des Eingangstakts mit dem Ausgang des Hochgeschwindigkeitstakts zu multiplizieren.

16. Vorrichtung nach Anspruch 15, wobei der Hochgeschwindigkeitstaktgenerator (50) einen Teiler (114) aufweist, um den Hochgeschwindigkeitstakt (60) und einen modifizierten Hochgeschwindigkeitstakt (64) mit einer dritten Frequenz kleiner als die zweite Frequenz des Hochgeschwindigkeitstakts abzugeben;

der Hochgeschwindigkeitstakt das am wenigsten signifikante Bit liefert; und

der modifizierte Hochgeschwindigkeitstakt anstelle des Hochgeschwindigkeitstaktes mit dem Synchronzähler (48) des ersten Phasenschiebers (44) gekoppelt ist.

17. Vorrichtung nach Anspruch 15, wobei die Vorrichtung eine monolithische Vorrichtung integriert auf einem Halbleiterchip ist.

18. Vorrichtung nach Anspruch 17, wobei die monolithische Vorrichtung eine CMOS-Vorrichtung ist.

19. Ein Analog-zu-Digital-Signal-Umwandlungsverfahren, wobei die folgenden Schritte vorgesehen sind:

Erzeugung eines analogen Rampensignals (18);
Erzeugung einer Sequenz von Gray-Code-DI-

gitalzählungen oder -Zählerständen;
Vergleichen einer Vielzahl von Analogsignalen mit dem analogen Rampensignal zur Erzeugung einer entsprechenden Vielzahl von Vergleichssignalen; jeweiliges Speichern einer Vielzahl von Digitalsignalen in einer Vielzahl von ersten Registern (24A, 24B) während einer Umwandlungsperiode, wobei jedes Digitalsignal der Vielzahl von Digitalsignalen basiert auf einem entsprechenden Analogsignal der Vielzahl von Analogsignalen, wobei jedes Digitalsignal in einem entsprechenden ersten Register basierend auf einem Vergleichssignal der Vielzahl von Vergleichssignalen gespeichert wird;

sequentielles Auswählen von Digitalsignalen aus der Vielzahl von ersten Registern;
Wandeln oder Umwandeln der ausgewählten Digitalsignale in entsprechende Binärsignale; wobei das Verfahren **dadurch gekennzeichnet ist, dass** es weiterhin einen Schritt des Transferierens oder Übertragens der sequentiell ausgewählten Digitalsignale zu einem Metastabilitätsauflösungsregister (36) umfaßt, und zwar zu einer vorbestimmten Zeit nach der Umwandlungs- oder Wandlungsperiode, um eine Metastabilität der sequentiell ausgewählten Digitalsignale aufzulösen, bevor sie in die erwähnten entsprechenden Digitalsignale umgewandelt werden.

20. Verfahren nach Anspruch 19, wobei der Schritt des jeweiligen Speicherns der Vielzahl von Digitalsignalen einen Schritt des Speicherns einer Sequenz von Digitalsignalen umfaßt, und zwar während einer Sequenz von Umwandlungsperioden basierend auf einer entsprechenden Sequenz von Analogsignalen; und

wobei der Schritt des Übertragens bzw. des Transferierens einen Schritt des Übertragens der Sequenz von Digitalsignalen zu dem Metastabilitätsauflösungsregister (36) mit einer ersten Datenrate umfaßt.

21. Verfahren nach Anspruch 20, wobei der Schritt des Speicherns einer Sequenz von Digitalsignalen einen Schritt des Speicherns jedes Digitalsignals der Sequenz von Digitalsignalen umfaßt, und zwar in dem mindestens einen entsprechenden ersten Register (24) während jeder Wandlungsperiode der Sequenz von Wandlungsperioden; und

wobei der Schritt des Transferierens oder Übertragens der Sequenz von Digitalsignalen einen Schritt des Übertragens jedes Digitalsignals der Sequenz von Digitalsignalen zu dem Metastabilitätsauflösungsregister (36) umfaßt, und zwar zu der vorbestimmten Zeit nach jeder Wandlungsperiode.

**22.** Verfahren nach Anspruch 20, wobei der Schritt des Speicherns einer Sequenz von Digitalsignalen die folgenden Schritte aufweist:

Erzeugen einer Sequenz von digitalen Zählungen oder Zählerständen mit einer zweiten Datenrate, die höher ist als die erste Datenrate; und
Speichern jedes Digitalsignals der Sequenz von Digitalsignalen in dem ersten Register (24) als eine digitale Zählung oder einen Zählerstand der Sequenz von digitalen Zählungen oder Zählerständen.

**23.** Verfahren nach Anspruch 19, wobei der Schritt des sequentiellen Auswählens von Digitalsignalen einen Schritt des Auswählens einer Sequenz von Digitalsignalen umfaßt, und zwar aus der Vielzahl von ersten Registern mit einer ersten Datenrate; und
wobei der Schritt des Übertragens des sequentiell ausgewählten Digitalsignals einen Schritt des Übertragens der Sequenz von ausgewählten Digitalsignalen zu dem zweiten Register mit der ersten Datenrate umfaßt.

**24.** Verfahren nach Anspruch 23, wobei der Schritt des jeweiligen Speicherns einer Vielzahl von Digitalsignalen die folgenden Schritte aufweist:

Erzeugen der Sequenz von digitalen Zählerständen mit einer zweiten Datenrate die höher ist als die erste Datenrate; und
Speichern jedes Digitalsignals in dem entsprechenden ersten Register als eines der Sequenz von digitalen Zählungen.

**25.** Verfahren nach Anspruch 24, wobei der Schritt des Wandelns des sequentiell ausgewählten Digitalsignals ferner das Umwandeln des sequentiell ausgewählten Digitalsignals transferiert zum zweiten Register von einem Gray-codierten Digitalsignal zu einem metastabilitätsaufgelösten Standard-Binär-Digitalsignal umfaßt.

**26.** Verfahren nach Anspruch 24, wobei der Schritt des Auswählens einer Sequenz von Digitalsignalen einen Schritt der Auswahl einer Sequenz von Digitalsignalen umfaßt, und zwar basierend auf einem Eingangstakt mit einer ersten Frequenz derart, dass die Sequenz der Digitalsignale ausgewählt wird mit der ersten Datenrate.

**27.** Verfahren nach Anspruch 26, wobei der Schritt des Erzeugens der Sequenz der Gray-Code-Digitalzählungen einen Schritt des Erzeugens der Sequenz von Gray-Code-Digitalzählungen umfaßt, und zwar basierend auf einem Hochgeschwindigkeitstakt mit einer zweiten Frequenz höher als die erste Frequenz des Eingangstakts derart, dass die Sequenz der digitalen Zählungen mit der zweiten Datenrate erzeugt wird.

**28.** Verfahren nach Anspruch 27, wobei jedes Digitalsignal der Vielzahl von Digitalsignalen N-Bits aufweist; jeder der Gray-Code-Digitalzählungen der Sequenz von Gray-Code-Digitalzählungen ein am wenigsten signifikantes Bit aufweist; und
der Schritt des Erzeugens der Sequenz der Gray-Code-Digitalzählungen basierend auf dem Hochgeschwindigkeitstakt einen Schritt des Kippens oder Schaltens des am wenigsten signifikanten Bits mit der zweiten Frequenz des Hochgeschwindigkeitstakts umfaßt.

**29.** Verfahren nach Anspruch 28, wobei der Schritt des Erzeugens der Sequenz von Gray-Code-Digitalzählungen basierend auf dem Hochgeschwindigkeitstakt einen Schritt des Erzeugens von mindestens einem der N-Bits der Gray-Code-Digitalzählungen umfaßt, und zwar basierend auf einer Phasenverschiebung des Hochgeschwindigkeitstakts.

**30.** Verfahren nach Anspruch 29, wobei der Schritt des Erzeugens von mindestens einem der N-Bits der Gray-Code-Digitalzählungen basierend auf der Phasenverschiebung des Hochgeschwindigkeitstakts einen Schritt des Erzeugens des am wenigsten signifikanten Bits als eine 90° Phasenverschiebungsversion des Hochgeschwindigkeitstakts umfasst.

## Revendications

**1.** Appareil comprenant :

un générateur de rampe analogique (30) pour fournir un signal de rampe analogique (18) ;
un générateur de code de Gray (45) pour fournir une séquence de comptages numériques ;
une pluralité de circuits convertisseurs (10A, 10B) pour convertir les signaux analogiques en signaux numériques, chaque circuit convertisseur étant couplé à un générateur de rampe analogique et au générateur de code de Gray de façon à recevoir le signal de rampe analogique (18) de la séquence de comptages numériques, chacun des circuits convertisseurs comprenant :

un comparateur (20) pour comparer un signal analogique au signal de rampe analogique et fournir un signal de sortie de comparateur ;
un premier registre (24) pour mémoriser un signal numérique pendant une durée de conversion en tant que premier comptage numérique de la séquence de comptages numériques en réponse au signal de sortie du comparateur ;

un multiplexeur (26, 54) couplé au premier registre (24A, 24B) de chaque circuit convertisseur (10A, 10B) de la pluralité de circuits convertisseurs pour sélectionner un signal numérique à partir de l'un de la pluralité de circuits convertisseurs et fournir le signal numérique sélectionné (57) ;

un convertisseur de code de Gray en binaire (38) couplé pour convertir le signal numérique sélectionné en binaire ;

l'appareil étant **caractérisé en ce qu'**il comprend en outre un registre de résolution de métastabilité (36) couplé au multiplexeur qui mémorise le signal numérique sélectionné à un instant prédéterminé après la période de conversion et fournit un signal numérique résolu en métastabilité sur la base du signal numérique sélectionné, le signal résolu en métastabilité étant converti par le convertisseur de code de Gray en binaire.

2. Appareil selon la revendication 1, dans lequel :

chacun de la pluralité de circuits convertisseurs convertit une séquence de signaux analogiques en une séquence correspondante de signaux numériques pendant une séquence de périodes de conversion ;

le registre résolvant la métastabilité (36) inclut une horloge d'entrée (68) pour mémoriser la séquence de signaux numériques à une première cadence de données ; et

le générateur de code de Gray (45) fournit la séquence de comptages numériques à une seconde cadence de données, la seconde cadence de données étant supérieure à la première cadence de données, chaque signal numérique de la séquence de signaux numériques étant mémorisé dans le premier registre (24) en tant que premier comptage numérique de la séquence de comptages numériques.

3. Appareil selon la revendication 2, dans lequel le circuit de résolution de métastabilité (59) mémorise chaque signal numérique de la séquence de signaux numériques à l'instant prédéterminé après chaque période de conversion de la séquence de périodes de conversion.

4. Appareil selon la revendication 1, comprenant en outre une horloge d'entrée (68) ayant une première fréquence, le multiplexeur (26, 54) étant couplé à l'horloge d'entrée de façon à sélectionner une séquence de signaux numériques de la pluralité de circuits convertisseurs (10A, 10B) et à fournir la séquence de signaux numériques sélectionnée à une première cadence de données sur la base de la première fréquence de l'horloge d'entrée.

5. Appareil selon la revendication 4, dans lequel le multiplexeur (26, 54) fournit chaque signal numérique sélectionné pendant un premier cycle respectif de l'horloge d'entrée (68).

6. Appareil selon la revendication 5, comprenant en outre un circuit de résolution de métastabilité (59) incluant un registre d'entrée (55) couplé à l'horloge d'entrée (68) et au multiplexeur (26, 54) pour recevoir la séquence de signaux numériques sélectionnés à la première cadence de données et mémoriser chaque signal numérique sélectionné pendant le premier cycle respectif de l'horloge d'entrée (68).

7. Appareil selon la revendication 6, dans lequel le circuit de résolution de métastabilité (59) comprend en outre le registre de résolution de métastabilité (36) couplé à l'horloge d'entrée (68) et au registre d'entrée (55) pour recevoir la séquence de signaux numériques sélectionnés à la première cadence de données et mémoriser chaque signal numérique sélectionné pendant un second cycle respectif de l'horloge d'entrée après le premier cycle respectif, le registre de résolution de métastabilité (36) fournissant le signal numérique résolu en métastabilité pour chaque signal numérique sélectionné.

8. Appareil selon la revendication 7, dans lequel :

le générateur de code de Gray (45) fournit la séquence de comptages numériques à une seconde cadence de données, la seconde cadence de données étant plus élevée que la première cadence de données, et

pour chaque convertisseur (10A, 10B), le signal numérique est mémorisé dans le premier registre (24A, 24B) en tant que premier comptage numérique de la séquence de comptages numériques.

9. Appareil selon la revendication 8, dans lequel le convertisseur de code de Gray en binaire (38) est couplé au registre de résolution de métastabilité (36) de façon à recevoir le signal numérique résolu en métastabilité, pour fournir un signal numérique binaire standard résolu en métastabilité sur la base du signal numérique résolu en métastabilité.

10. Appareil selon la revendication 9, comprenant en outre une horloge rapide ayant une seconde fréquence supérieure à la première fréquence de l'horloge d'entrée dans lequel :

le signal numérique comprend N bits ;
chaque comptage numérique de la séquence de comptages numériques comprend un bit le moins significatif, un bit voisin du bit le moins significatif et (N-2) bits plus significatifs ;
le générateur de code de Gray (45) est couplé à l'horloge rapide et constitué et disposé pour basculer le bit le moins significatif à la seconde fréquence d'horloge rapide, de sorte que le générateur de code de Gray produit la séquence de comptages numériques à la seconde cadence de données.

11. Appareil selon la revendication 10, dans lequel la seconde fréquence d'horloge rapide est au moins 12 fois plus élevée que la première fréquence d'horloge d'entrée.

12. Appareil selon la revendication 10, dans lequel le générateur de code de Gray (45) comprend :

un compteur synchrone (48) couplé à l'horloge rapide (64) ayant une sortie de compteur synchrone incluant un bit le moins significatif du compteur ;
un codeur de Gray OU Exclusif (46) couplé à la sortie du compteur synchrone pour fournir (N-2) bits plus significatifs ; et
un premier déphaseur (44) couplé à l'horloge rapide et au compteur synchrone pour recevoir le bit le moins significatif du compteur, et fournir le bit voisin du bit le moins significatif.

13. Appareil selon la revendication 12, dans lequel le générateur de code de Gray (45) comprend en outre un second déphaseur (42) couplé à l'horloge rapide pour fournir le bit le moins significatif en tant que version déphasée de l'horloge rapide.

14. Appareil selon la revendication 13, dans lequel le second déphaseur (42) fournit le bit le moins significatif en tant que version déphasée de 90° de l'horloge rapide, le second déphaseur comprenant :

un retard commandé en tension (78) ayant une entrée de commande et couplé à l'horloge rapide, pour fournir un signal d'horloge retardé sur la base de l'horloge rapide et d'un signal de commande reçu sur l'entrée de commande ;
un circuit de mise en forme (77) couplé au retard commandé en tension pour recevoir le signal d'horloge retardé et fournir un signal d'horloge retardé de rapport cyclique 50 % ;
un circuit détecteur de phase (75, 80) couplé à l'horloge rapide et au circuit de mise en forme pour recevoir le signal d'horloge retardé à un rapport cyclique de 50 % et fournir le bit le moins significatif et un signal de phase sur la base de la différence entre l'horloge rapide et le signal d'horloge retardé de rapport cyclique 50 % ; et
un amplificateur (82) couplé au circuit détecteur de phase pour recevoir le signal de phase, pour fournir le signal de commande au retard commandé en tension.

15. Appareil selon la revendication 12, comprenant en outre un générateur d'horloge rapide (50) pour recevoir l'horloge d'entrée (68) et multiplier la première fréquence d'horloge d'entrée pour fournir l'horloge rapide.

16. Appareil selon la revendication 15, dans lequel :

le générateur d'horloge rapide (50) comprend un diviseur (114) pour fournir l'horloge rapide (60) et une horloge rapide modifiée (64) ayant une troisième fréquence inférieure à la seconde fréquence d'horloge rapide ;
l'horloge rapide fournit le bit le moins significatif ; et
l'horloge rapide modifiée, au lieu de l'horloge rapide, est couplée au compteur synchrone (48) et au premier déphaseur (44).

17. Appareil selon la revendication 15, dans lequel l'appareil est un dispositif monolithique intégré sur une puce semiconductrice.

18. Appareil selon la revendication 17, dans lequel le dispositif monolithique est un dispositif CMOS.

19. Procédé de conversion analogique/numérique comprenant les étapes suivantes :

produire un signal analogique en rampe (18) ;
produire une séquence de comptage numérique de code de Gray ;
comparer une pluralité de signaux analogiques au signal de rampe analogique pour produire une pluralité correspondante de signaux de comparaison ;
mémoriser respectivement une pluralité de signaux numériques dans une pluralité de premiers registres (24A, 24B) pendant une période de conversion, chaque signal numérique de la pluralité de signaux numériques étant basé sur un signal analogique correspondant de la pluralité de signaux analogiques, chaque signal numérique étant mémorisé dans un premier registre correspondant sur la base d'un signal de comparaison parmi la pluralité de comparaisons ;
sélectionner séquentiellement des signaux numériques à partir de la pluralité de premiers registres ;

convertir les signaux numériques sélectionnés en signaux binaires correspondants ;

le procédé étant **caractérisé en ce qu'**il comprend en outre l'étape consistant à transférer les signaux numériques sélectionnés séquentiellement à un registre de résolution de métastabilité (36) à un premier instant prédéterminé après la période de conversion pour résoudre la métastabilité des signaux numériques sélectionnés séquentiellement, avant qu'ils soient convertis en les signaux numériques correspondants.

20. Procédé selon la revendication 19, dans lequel :

l'étape de mémorisation respective de la pluralité de signaux numériques comprend une étape de mémorisation d'une séquence de signaux numériques pendant une séquence de périodes de conversion sur la base d'une séquence correspondante de signaux analogiques ; et

l'étape de transfert inclut une étape de transfert de la séquence de signaux numériques vers le registre de résolution de métastabilité (36) à une première cadence.

21. Procédé selon la revendication 20, dans lequel :

l'étape de mémorisation d'une séquence de signaux numériques inclut une étape de mémorisation de chaque signal numérique de la séquence de signaux numériques dans ledit au moins un premier registre correspondant (24) pendant chaque période de conversion de la séquence de périodes de conversion ; et

l'étape de transfert de la séquence de signaux numériques inclut une étape de transfert de chaque signal numérique de la séquence de signaux numériques vers le registre de résolution de métastabilité (36) à l'instant prédéterminé après chaque période de conversion.

22. Procédé selon la revendication 20, dans lequel l'étape de mémorisation d'une séquence de signaux numériques inclut les étapes suivantes :

produire la séquence de comptages numériques à une seconde cadence de données, la seconde cadence de données étant supérieure à la première cadence de données ; et

mémoriser chaque signal numérique de la séquence de signaux numériques dans le premier registre (24) en tant que premier comptage numérique de la séquence de comptages numériques.

23. Procédé selon la revendication 19, dans lequel :

l'étape de sélection séquentielle de signaux numériques comprend une étape de sélection d'une séquence de signaux numériques à partir de la pluralité de premiers registres à une première cadence de données ; et

l'étape de transfert du signal numérique sélectionné séquentiellement comprend une étape de transfert de la séquence de signaux numériques sélectionnés vers le second registre à la première cadence de données.

24. Procédé selon la revendication 23, dans lequel l'étape de mémorisation respective d'une pluralité de signaux numériques comprend des étapes suivantes :

produire la séquence de comptages numériques à une seconde cadence de données, la seconde cadence de données étant supérieure à la première cadence de données ; et

mémoriser chaque signal numérique dans le premier registre respectif en tant que l'un de la séquence de comptages numériques.

25. Procédé selon la revendication 24, dans lequel l'étape de conversion du signal numérique sélectionné séquentiellement comprend en outre la conversion du signal numérique sélectionné séquentiellement transféré au second registre à partir d'un signal numérique codé en code de Gray en un signal numérique binaire standard résolu en métastabilité.

26. Procédé selon la revendication 24, dans lequel l'étape de sélection d'une séquence de signaux numériques comprend une étape de sélection d'une séquence de signaux numériques sur la base d'une horloge d'entrée ayant une première fréquence de sorte que la séquence de signaux numériques est sélectionnée à la première cadence de données.

27. Procédé selon la revendication 26, dans lequel l'étape de génération de la séquence de comptages numériques en code de Gray inclut une étape de génération de la séquence de comptages numériques en code de Gray sur la base d'une horloge rapide ayant une seconde fréquence supérieure à la première fréquence d'horloge d'entrée de sorte que la séquence de comptages numériques est produite à la seconde cadence de données.

28. Procédé selon la revendication 27, dans lequel :

chaque signal numérique de la pluralité de signaux numériques comprend N bits ;

chaque comptage numérique en code de Gray de la séquence de comptages numériques en code de Gray inclut un bit le moins significatif ;

et

l'étape de génération de la séquence de comptages numériques en code de Gray sur la base de l'horloge rapide inclut une étape de basculement du bit le moins significatif à la seconde fréquence de l'horloge rapide.

29. Procédé selon la revendication 28, dans lequel l'étape de génération de la séquence de comptages numériques en code de Gray sur la base de l'horloge rapide inclut une étape de génération d'au moins un des N bits des comptages numériques en code de Gray sur la base d'un déphasage de l'horloge rapide.

30. Procédé selon la revendication 29, dans lequel l'étape de génération d'au moins un des N bits des comptages numériques en code de Gray sur la base d'un déphasage de l'horloge rapide inclut une étape de génération du bit le moins significatif en tant que version déphasée de 90° de l'horloge rapide.

15

20

COMP

21

35

METASTABILITY
RESOLVING
CIRCUIT

47

~18

30

ANALOG
WAVEFORM
GENERATOR

~62

45

GRAY
CODE
GENERATOR

## FIG. 1

35

21

11

N-BIT DATA
LATCH

17

19

N-BIT
FLIP FLOP

47

~62

45

GRAY CODE
GENERATOR

## FIG. 2

RAMP_BIAS

*30*

*39*

*32*

*18*

*23*

*28A*

*34*

*28*

RESET

PROGRAMMABLE
CURRENT
SOURCE

*31*

*27A*

*27*

RAMP_REF

OPERATIONAL
TRANSCONDUCTANCE
AMPLIFIER

*29A*

TIMING
CIRCUIT

*33*

*33A*

RAMP
ADJUST
CIRCUIT

*29*

# FIG. 2A

**FIG. 3**

OUTPUT CONTROL SHIFT REGISTER — 54

SYNC INPUT
DATA IN
CLOCK IN
68 INPUT CLOCK (7 MHz NOMINAL)

UNCLOCKED COMPARATOR m
15B  12B  S/H m  14B  16B  25B  23B  10B
RAMP  20B  N-BIT INPUT LATCH  22B  N-BIT GRAY CODE BUS  62  24B  LATCH INPUT  N-BIT TRANSFER LATCH  26B  N-BIT DATA OUT  OUTPUT ENABLE  N-BIT OUTPUT BUS  57

OUTPUT m
m TOTAL OUTPUTS
OUTPUT 1

m COLUMNS TOTAL

UNCLOCKED COMPARATOR 1
15A  12A  S/H 1  14A  16A  25A  23A  10A
RAMP  20A  N-BIT INPUT LATCH  22A  24A  LATCH INPUT  N-BIT TRANSFER LATCH  26A  N-BIT DATA OUT  OUTPUT 70A ENABLE  70B  N-BIT OUTPUT BUS

END OF LINE TRANSFER FROM CONTROLLER (NOT SHOWN)

DATA IN  62  N-BIT GRAY CODE BUS  18

READOUT
N-BIT SENSE AMPLIFIER — 53
N-BIT INPUT REGISTER — 55
N-BIT METASTABILITY RESOLVING REGISTER — 36
N-BIT GRAY TO BINARY — 38
N-BIT OUTPUT REGISTER — 71
N OUTPUT DRIVERS — 73
47 N-BIT BINARY OUT
59

LINE DRIVERS — 61
(N-2) MSBs  56
OUTPUT SYNCHRONIZING REGISTER — 51
HIGH SPEED CLOCK
N-2 BIT GRAY ENCODER — 46
N-2 BIT BINARY SYNCHRONOUS COUNTER — 48
49  (LSB)
LSB+1  58
NEGATIVE EDGE FLIP FLOP  44  D  CK
HIGH SPEED CLOCK (84 MHz NOMINAL)

LSB  60
90 DEGREE PHASE SHIFTER — 42
HIGH SPEED CLOCK  45

CLOCK MULTIPLYING PHASE LOCKED LOOP — 50
INPUT CLOCK
64  HIGH SPEED CLOCK

FIG. 4

FIG. 5

EP 0 836 768 B1

FIG. 6

_50_

_120_    _122_    _110_

| VCO | | SQUARING CIRCUIT |

_108_

_110_

| SQUARING CIRCUIT |

_124_～

_104_

_112_

_100_    _102_    _114_

| PHASE DETECTOR | | DIVIDE BY n |

～_68_    ～_64_    ～_60_

INPUT CLOCK    HIGH SPEED CLOCK    LSB

# FIG. 7

FIG. 8

EP 0 836 768 B1

FIG. 9

EP 0 836 768 B1

**FIG. 10**